# EUROPEAN PATENT APPLICATION

(11) **EP 3 798 993 A1**
(43) Date of publication of application: **31.03.2021**
(21) Application number: 19207741.0
(22) Date of filing: 07.11.2019
(51) Int. Cl.: G06T 19/00

(54) **DESIGN ENGINEERING TOOLS FOR VISUALIZING EXISTING UTILITY LINES WITHIN A LAND AREA AND VALIDATING PLACEMENT OF NEW UTILITY LINES**

(30) Priority: 25.09.2019 US 201916583027
(71) Applicant: ID Technologies Inc., Calgary, AB T2H 2Z9 (CA)
(72) Inventor: AGOURIDIS, Dimitris, Calgary, Alberta AB T2H 2Z9 (CA)
(74) Representative: Betten & Resch

(57) **Abstract**

A design engineering tool and associated method are disclosed. The design engineering tool and method allow a user to view a photo of a land area or a map derived from the photo, to overlay the photo or map with existing utility lines and proposed utility lines, and to generate alerts regarding any conflict that is identified between a proposed utility line and an existing utility line. The tool also has an augmented reality mode where it displays visualizations of existing and proposed utility lines over a real-time image obtained from a camera. Optionally, the exact location and condition of existing utility lines can be determined using radar and camera devices that generate data describing the location and physical characteristics of the utility lines. The generated data can be imported into the design engineering tool.

## Description

### FIELD OF THE INVENTION

A design engineering tool and associated method are disclosed. The design engineering tool and method allow a user to view a photo of a land area or a map derived from the photo, to overlay the photo or map with existing utility lines and proposed utility lines, and to generate alerts regarding any conflict that is identified between a proposed utility line and an existing utility line. The tool also has an augmented reality mode where it displays visualizations of existing and proposed utility lines over a real-time image obtained from a camera. Optionally, the exact location and condition of existing utility lines can be determined using radar and camera devices that generate data describing the location and physical characteristics of the utility lines. The generated data can be imported into the design engineering tool.

### BACKGROUND OF THE INVENTION

Subsurface utility engineering is a branch of engineering that involves identifying existing utility lines relevant to a building project, managing any risks involved with the utility lines, utility coordination, utility relocation design and coordination, utility condition assessment, communication of utility data to concerned parties, utility relocation cost estimates, implementation of utility accommodation policies, and utility design. Subsurface utility engineering typically is performed for every significant building project to ensure that the project does not interfere with existing utility lines and because the building itself needs to ultimately connect to the utility lines.

Subsurface utility engineering in the prior art typically involves computer-aided design (CAD) drawings that show the relevant land area, such as a neighborhood or city block. The drawings can display different layers that include items found underground, such as water pipes, sewage pipes, electrical conduits, gas lines, fiber optical lines, traditional telephone and cable TV lines, and other types of lines (herein, these collectively will be called "utility lines"). Typically, a designer will start with the original design plans for a neighborhood or city block and add in utility lines that are required for the project. Notably, these plans are developed during the design phase. When the utility lines are actually installed, the plans will not necessarily be followed in a precise manner. In addition, when repairs and improvements are made to the utility lines or the streets or buildings, the placement or content of the utility lines may change without the CAD drawings being updated. Thus, CAD drawings do not necessarily accurately reflect the reality of the utility lines as they actually exist in the field.

In a separate technology area, the prior art also includes satellite images that can be retrieved for any location on earth, such as a neighborhood or city block. Such an image can be geo-referenced, meaning that geo-location data (such as longitude data and latitude data) is associated with each point, or some of the points, within the image. An example of a web site and app that can provide such images and maps derived from the imagery is the service known by the trademark "GOOGLE MAPS."

To date, there has been no mechanism that combines the two technologies together, namely, the ability to create and/or view CAD layers on a photo or on a map derived from the photo. There also has been no such mechanism that could further identify conflicts between existing utility lines and a proposed utility line that an engineer wishes to implement.

In addition, local governments, developers, utility companies, and others have an ongoing need to know the exact location of various assets in the field, such as utility lines, utility poles, traffic signals, control boxes, electrical transformers, telecommunication switches, fire hydrants, sewer line manholes, water pumps, and other items. Typically, an entity will consult an original design map or computer-aided design (CAD) drawing to find the location where the asset was originally planned to be built. These maps and drawings are not always accurate, however, because the construction crew may not have followed the plan precisely, or the location of the asset may have changed over time due to subsequent repairs or renovations that may not be reflected in maps or drawings.

As a result, these entities still need to perform physical inspections where a person inspects the physical item in the field and uses traditional surveying and measurement tools to determine the relative or absolute location of the asset. For instance, a surveyor often will use a total station (TS), which is an electronic and optical instrument used for surveying. A TS typically comprises an electronic transit theodolite, an electronic distance measurement mechanism to measure vertical angles, horizontal angles, and the slope distance from the instrument to a particular point, and a computer to collect data and perform triangulation calculations. A surveyor also will use real-time kinematic (RTK) devices, which are devices that use a satellite navigation technique to enhance the precision of position data derived from satellite-based positioning systems such as GNSS or GPS systems. RTK uses measurements of the phase of the signal's carrier wave in addition to the information content of the signal and relies on a single reference station or interpolated virtual station to provide real-time corrections, providing up to centimeter-level accuracy.

For underground items, the person in the field often must physically dig holes to find the location and depth of the items. This is an expensive, time-consuming, and traffic-creating endeavor.

To date, the prior art does not include a satisfactory mechanism for integrating data from TS and RTK devices and other measurements and observations from the field. In addition, the need to physical inspect each asset and to collect data for each one is often tedious and time-consuming.

What is needed is a design tool that allows utility lines to be visualized within a photo of a land area or a map derived from the photo and that identifies any conflicts between existing utility lines and a utility line that is proposed in a design. What is further needed is a tool that allows a user to visualize the location of utility lines in the field. What is further needed are improved tools for locating existing utility lines and outputting data that allows the utility lines to be accurately shown in the design tool.

### SUMMARY OF THE INVENTION

A design engineering tool and associated method are disclosed. The design engineering tool and method allow a user to view a photo of a land area or a map derived from the photo, to overlay the photo or map with existing utility lines and proposed utility lines, and to generate alerts regarding any conflict that is identified between a proposed utility line and an existing utility line. The tool also has an augmented reality mode where it displays visualizations of existing and proposed utility lines over a real-time image obtained from a camera. Optionally, the exact location and condition of existing utility lines can be determined using radar and camera devices that generate data describing the location and physical characteristics of the utility lines. The generated data can be imported into the design engineering tool.

In one embodiment, a method of visualizing the location of utility lines within a land area is provided. The method comprises obtaining, by a computing device, a photo of a land area; obtaining, by the computing device, a computer aided design file comprising a plurality of objects, each object representing an existing utility line located underground in the land area; and displaying, by the computing device, images of the existing utility lines associated with the plurality of objects over the photo.

In another embodiment, a method of visualizing the location of utility lines within a land area is provided. The method comprises deriving a map from a photo of a land area; obtaining, by a computing device, the map; obtaining, by the computing device, a computer aided design file comprising a plurality of objects, each object representing an existing utility line located underground in the land area; and displaying, by the computing device, images of the existing utility lines associated with the plurality of objects over the map.

In another embodiment, a method of generating an augmented reality image of a land area is provided. The method comprises capturing a photo of a land area by a computing device; accessing data regarding existing utility lines located underground in the land area; and displaying, by the computing device, images of the existing utility over the photo.

In another embodiment, a method of generating an augmented reality image of a structure is provided. The method comprises obtaining a three-dimensional model of a structure; capturing a photo of the structure by a computing device; accessing data from the three-dimensional model for existing utility lines contained within the structure; and displaying, by the computing device, images of the existing utility lines over the photo.

### BRIEF DESCRIPTION OF THE DRAWINGS

Figure 1 depicts prior art hardware components of a client device.
Figure 2 depicts software components of a client device.
Figure 3 depicts prior art hardware components of a server.
Figure 4 depicts software components of a server.
Figure 5 depicts a design environment comprising a server and client device.
Figure 6A depicts an image of a land area.
Figure 6B depicts a utility overlay based on the image of Figure 6A.
Figure 6C depicts a utility overlay based on a map corresponding to the image of Figure 6A.
Figure 7A depicts a three-dimensional (3D) rendering of a land area and underground utility lines.
Figure 7B depicts a 3D rendering of conflicts between utility lines.
Figure 8 depicts a 3D rendering of terrain and underground utility lines.
Figure 9A depicts a utility overlay and a slice line manipulated by the user.
Figure 9B depicts a cross-section taken along the slide line of Figure 9A.
Figure 10 depicts a ground penetrating radar device.
Figure 11 depicts a robotic camera device.
Figure 12 depicts an augmented reality mode of a client device.
Figure 13A depicts a 3D model of a structure.
Figure 13B depicts an augmented reality mode within the structure shown in the 3D model of Figure 13A.
Figure 14 depicts an asset location determination method.
Figure 15 depicts a pole information capture method.
Figure 16A depicts a photo of a utility pole combined with data captured by a survey and measurement system.
Figures 16B, 16C, 16D, and 16E depict visualizations generated using the data shown in Figure 8A and other relevant data.

### DETAILED DESCRIPTION OF THE INVENTION

### DESIGN TOOL

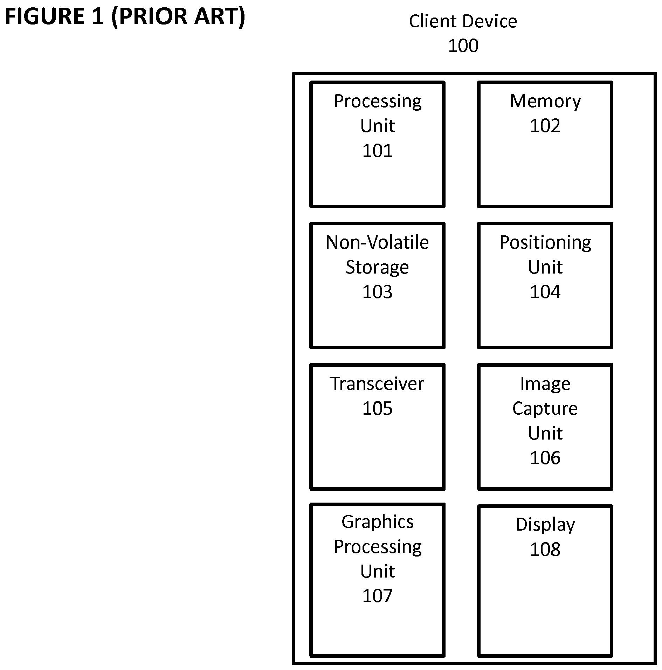

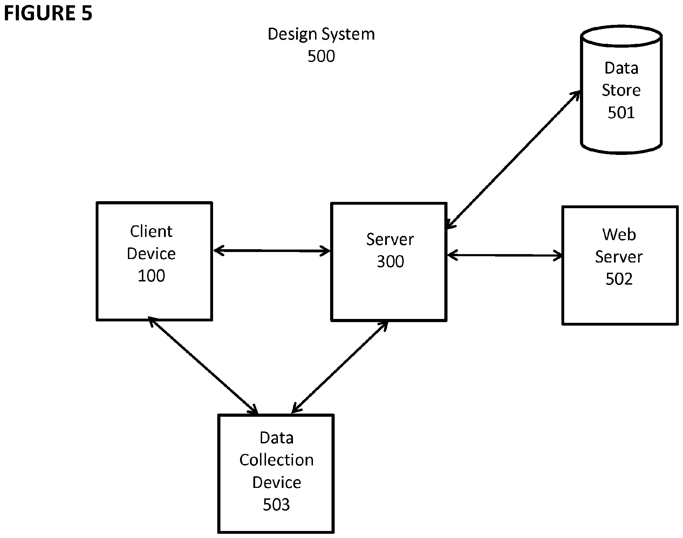

An embodiment of a computer-implemented design tool is depicted in Figures 1-5. The design tool is implemented using design system 500, which comprises client device 100 and server 300, as shown in Figure 5. Applicant refers internally to this embodiment as "KAMEL."

Client device 100 will first be described. Figure 1 depicts hardware components of client device 100. These hardware components are known in the prior art. Client device 100 is a computing device that comprises processing unit 101, memory 102, non-volatile storage 103, positioning unit 104, network interface 105, image capture unit 106, graphics processing unit 107, and display 108. Client device 100 can be a smartphone, notebook computer, tablet, desktop computer, gaming unit, wearable computing device such as a watch or glasses, or any other computing device.

Processing unit 101 optionally comprises a microprocessor with one or more processing cores. Memory 102 optionally comprises DRAM or SRAM volatile memory. Non-volatile storage 103 optionally comprises a hard disk drive or flash memory array. Positioning unit 104 optionally comprises a GPS unit or GNSS unit that communicates with GPS or GNSS satellites to determine latitude and longitude coordinates for client device 100, usually output as latitude data and longitude data. Network interface 105 optionally comprises a wired interface (e.g., Ethernet interface) or wireless interface (e.g., 3G, 4G, 5G, GSM, 802.11, protocol known by the trademark "BLUETOOTH," etc.). Image capture unit 106 optionally comprises one or more standard cameras (as is currently found on most smartphones, tablets, and notebook computers). Graphics processing unit 107 optionally comprises a controller or processor for generating graphics for display. Display 108 displays the graphics generated by graphics processing unit 107, and optionally comprises a monitor, touchscreen, or other type of display.

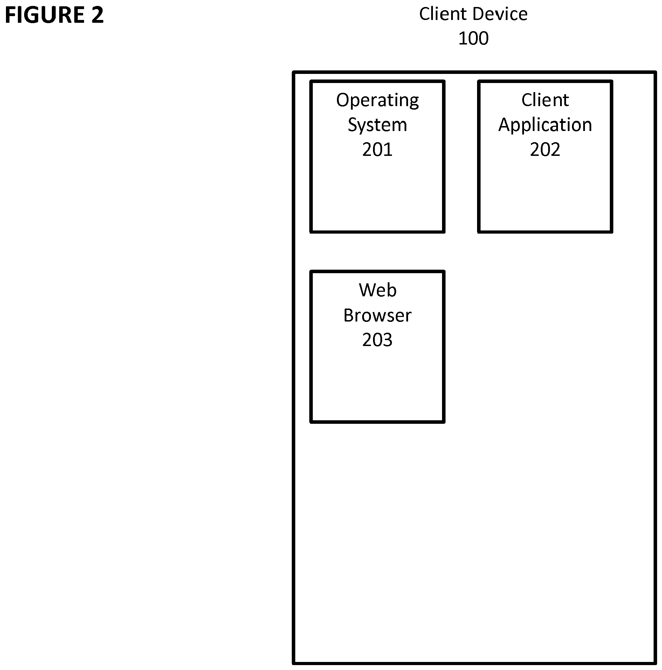

Figure 2 depicts software components of client device 100. Client device 100 comprises operating system 201 (such as the operating systems known by the trademarks "WINDOWS," "LINUX," "ANDROID," "IOS," or others), client application 202, and web browser 203.

Client application 202 comprises lines of software code executed by processing unit 101 to perform the functions described below. For example, client device 100 can be a smartphone or tablet sold with the trademark "GALAXY" by Samsung or "IPHONE" by Apple, and client application 202 can be a downloadable app installed on the smartphone or tablet. Client device 100 also can be a notebook computer, desktop computer, game system, or other computing device, and client application 202 can be a software application running on client device 100. Client application 202 forms an important component of the inventive aspect of the embodiments described herein, and client application 202 is not known in the prior art.

Web browser 203 comprises lines of software code executed by processing unit 101 to access web servers, display pages and content from web sites, and to provide functionality used in conjunction with web servers and web sites, such as the web browsers known by the trademarks "INTERNET EXPLORER," "CHROME," AND "SAFARI."

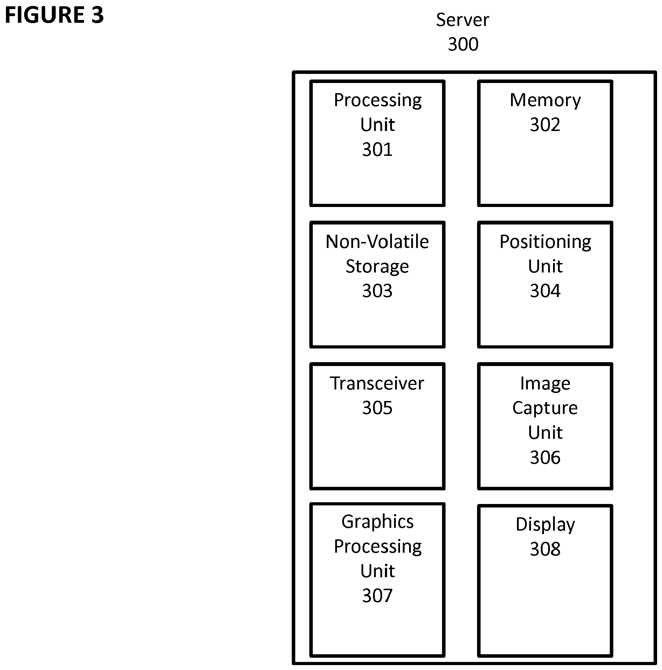

Server 300 will now be described. Figure 3 depicts hardware components of server 300. These hardware components are known in the prior art. Server 300 is a computing device that comprises processing unit 301, memory 302, non-volatile storage 303, positioning unit 304, network interface 305, image capture unit 306, graphics processing unit 307, and display 308. Server 300 can be a smartphone, notebook computer, tablet, desktop computer, gaming unit, wearable computing device such as a watch or glasses, or any other computing device.

Processing unit 301 optionally comprises a microprocessor with one or more processing cores. Memory 302 optionally comprises DRAM or SRAM volatile memory. Non-volatile storage 303 optionally comprises a hard disk drive or flash memory array. Positioning unit 304 optionally comprises a GPS unit or GNSS unit that communicates with GPS or GNSS satellites to determine latitude and longitude coordinates for client device 300, usually output as latitude data and longitude data. Network interface 305 optionally comprises a wired interface (e.g., Ethernet interface) or wireless interface (e.g., 3G, 4G, 5G. GSM, 802.11, protocol known by the trademark "BLUETOOTH," etc.). Image capture unit 306 optionally comprises one or more standard cameras (as is currently found on most smartphones, tablets, and notebook computers). Graphics processing unit 307 optionally comprises a controller or processor for generating graphics for display. Display 308 displays the graphics generated by graphics processing unit 307, and optionally comprises a monitor, touchscreen, or other type of display.

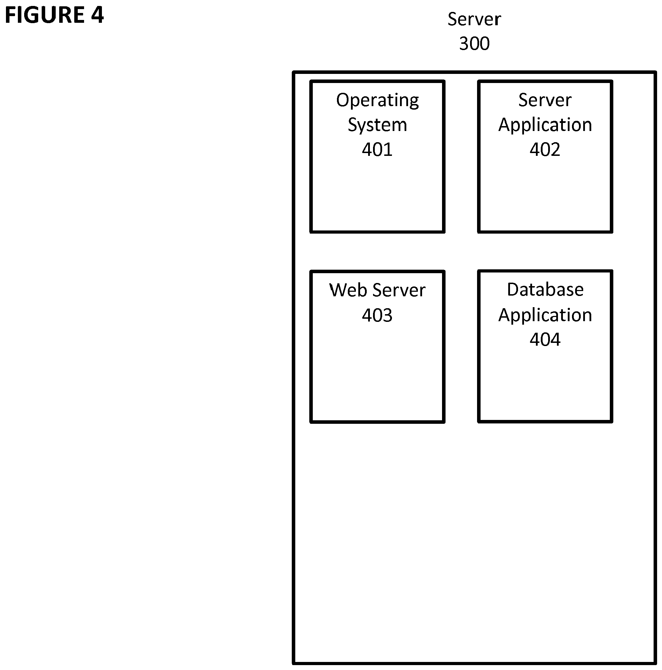

Figure 4 depicts software components of server 300. Server 300 comprises operating system 401 (such as the operating systems known by the trademarks "WINDOWS," "LINUX, "ANDROID," "IOS," or others), server application 402, web server 403, and database application 404.

Server application 402 comprises lines of software code executed by processing unit 301 to interact with client application 202 and to perform the functions described below. Server application 402 forms an important component of the inventive aspect of the embodiments described herein, and server application 402 is not known in the prior art.

Web server 403 is a web page generation program capable of interacting with web browser 203 on client device 100 to display web pages, such as the web server known by the trademark "APACHE."

Database application 404 comprises lines of software code executed by processing unit 301 to generate and maintain a database, such as an SQL database.

Figure 5 depicts design system 500, which comprises client device 100, server 300, data store 501, web server 502, and data collection device 503. One of ordinary skill in the art will appreciate that client device 100 and server 300 are exemplary and that design system 500 can include additional client devices 100 and servers 300.

Client device 100 and server 300 can communicate with each other over a wired or wireless network or through a local connection. Server 300 optionally communicates with data store 501, which, for example, can hold the data accessed by database application 404. Server 300 optionally communicates with web server 502, such as through the use of APIs. Web server 502 can be operated by a third-party.

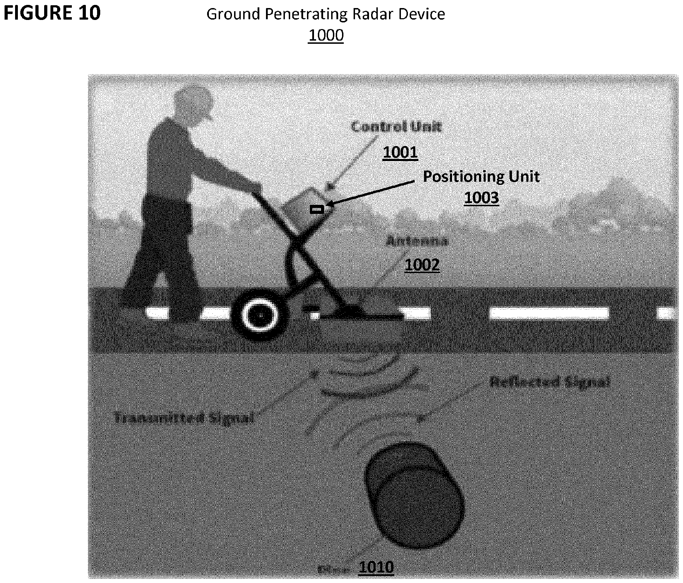

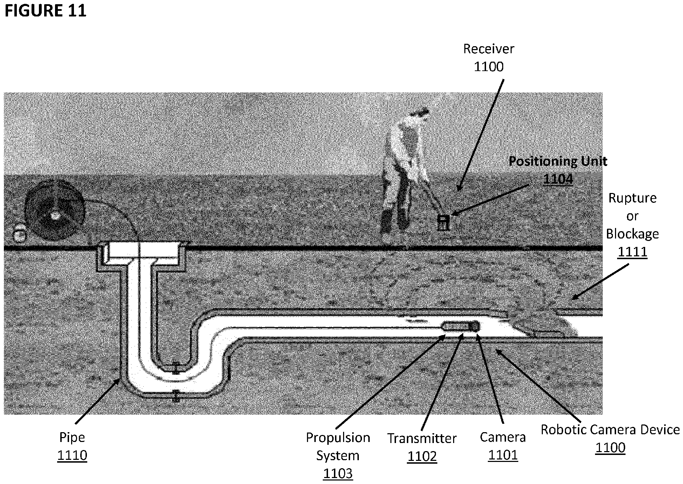

Client device 100 and server 300 optionally can each communicate with data collection device 503. Data collection device 503 can be a camera, a drone (which might include one or more cameras), ground penetrating radar device 1000 (discussed below with reference to Figure 10), robotic camera device 1100 (discussed below with reference to Figure 11), a TS, a camera, or any other device.

Server application 402 and client application 202 separately or collectively enable the integration of:
- Geo-referenced images of a land area, where the images are captured by image capture unit 106, image capture unit 306, or data collection device 503 or are obtained from data store 501 or web server 502;
- Maps derived from geo-referenced images of a land area;
   ▪ Topographical data for the land area;
   ▪ Data collected from a TS device, an RTK device, or any other client device; and
   ▪ CAD files or layers (which can be imported or created in KML, CSV, or DXF files), such as files or layers showing the intended location of existing utility lines.

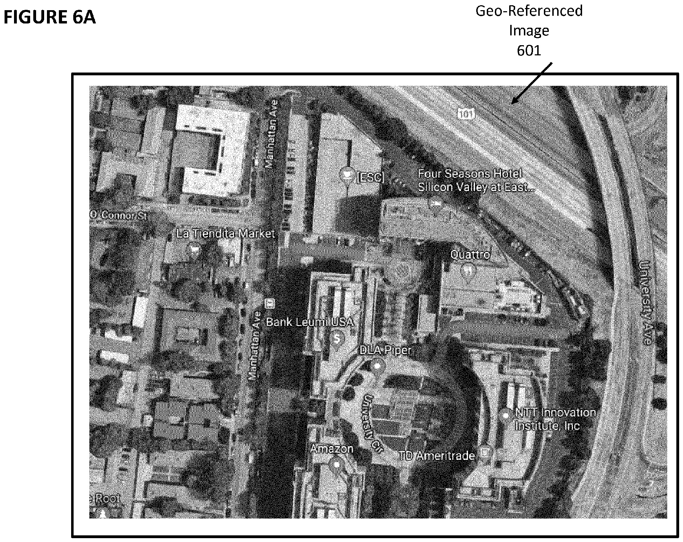

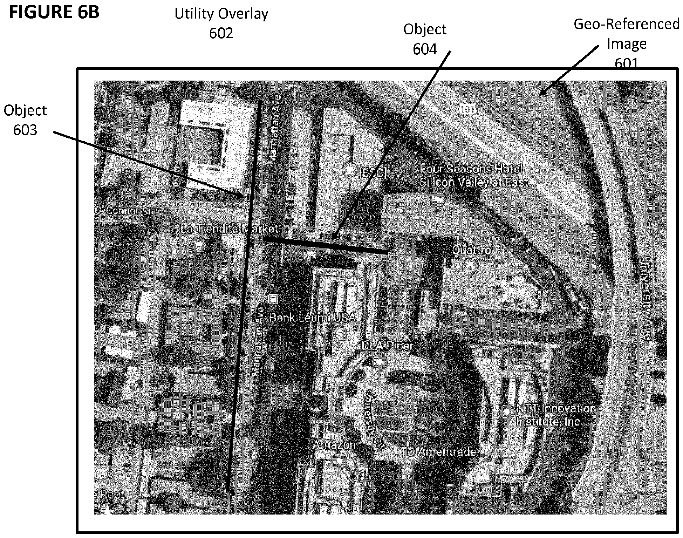

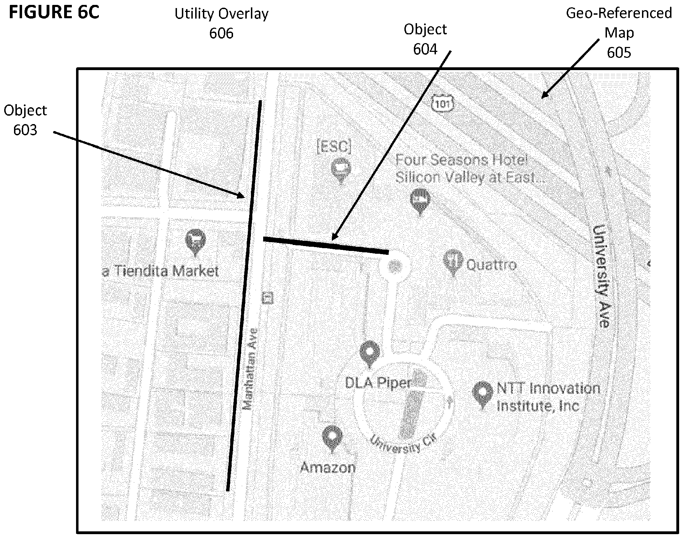

The operation of design system 500 will now be described with reference to an example shown in Figures 6A, 6B, and 6C. Figure 6A depicts geo-referenced image 601, which here is a satellite image taken of a neighborhood where the project is to be performed and includes geo-location data (not shown). Client device 100 and/or server 300 can obtain geo-referenced image 601 from data store 501, web server 502, or data collection device 503 (such as a camera on a drone). Geo-referenced image 601 is displayed on display 108 of client device 100 or display 308 of server 300.

Figure 6B depicts objects 603 and 604 overlaid on geo-referenced image 601 to generate utility overlay 602. Here, each of objects 603 and 604 has a visual form depicted within utility overlay 602 to indicate the location of physical objects that would be placed in the land area. For example, object 603 might represent a water main, and object 604 might represent a sewer pipe.

Each object, such as objects 603 and 604, comprises a dataset (which can be stored in non-volatile storage 103, non-volatile storage 303, data store 501, or elsewhere) that optionally includes the following:
- For each sampled point or segment of the physical object, the geo-location of the point or segment (e.g., latitude data and longitude data);
- For each sampled point or segment of the physical object, the depth of the point or segment from the surface;
- For each sampled point or segment of the physical object, the diameter or width of the physical object at that point or segment;
- The function of the physical object (e.g., water main, electrical conduit); and
- Other characteristics of the physical object.

Figure 6C depicts an alternative visualization. Here, geo-referenced image 601 is replaced with geo-referenced map 605, where geo-referenced image 601 and geo-referenced map 605 correspond to the same location. Client device 100 and/or server 300 can obtain geo-referenced map 605 from data store 501, web server 502, or data collection device 503 (such as a camera on a drone), or client device 100 or server 300 can generate geo-referenced map 605 dynamically from geo-referenced image 601, for example, by performing edge detection on geo-referenced image 601 to identify the outline of roads, freeways, buildings, etc. Optionally, client device 100 or server 300 can specify a correction vector for geo-referenced map 605 to account for visual disparities between geo-referenced map 605 and real world measurements, which can preserves the actual measured data while keeping geo-referenced map 605 visually correct.

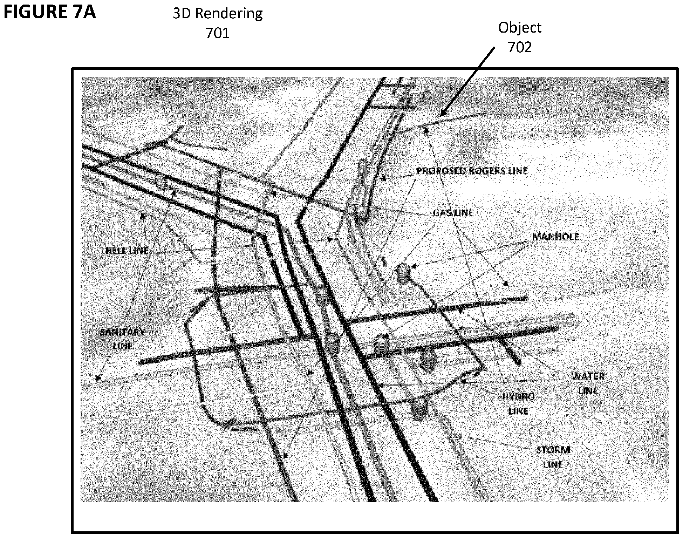

Figure 7A depicts another view that can be generated by client device 100 and/or server 300 and displayed on display 108 or display 308. 3D rendering 701 is generated. 3D rendering 701 shows the three-dimensional location of a plurality of utility lines each represented as an object. Here, exemplary object 702 is a water line.

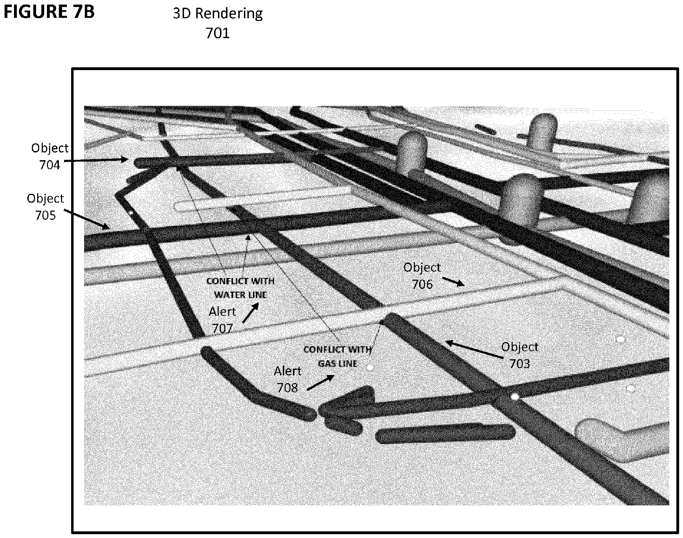

Figure 7B depicts a close-up of a portion of the view from Figure 7A. Here, a designer has added object 703, which is a utility line that he or she wishes to add during the design phase of a project. Client device 100 and/or server 300 determines that there is a conflict between object 703 and existing object 704 (a water line), object 705 (a water line), and object 706 (a gas line). An operator of client device 100 and/or server 300 can specify parameters that define the existence of a conflict. For example, actual physical contact between objects can be deemed to be a conflict, or the operator can set a threshold that constitutes a minimum distance that must be maintained at all times between two particular object types (e.g., 1 meter separation between sewer lines and water lines). If the planned utility line does not abide by that threshold, then a conflict occurs.

In Figure 7B, alerts 707 and 708 are generated in textual form to indicate the existing of conflicts between object 703 and each of objects 704, 705, and 706.

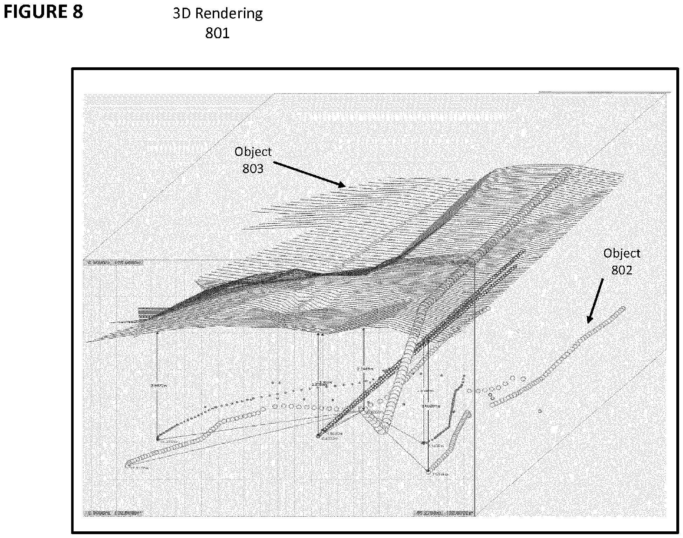

Figure 8 depicts another view that can be generated by client device 100 and/or server 300 and displayed on display 108 or display 308. Here, 3D rendering 801 is created. 3D rendering 801 shows the three-dimensional location of a plurality of utility lines each represented as an object. 3D rendering 801 also shows topographical features, such as object 803 (the ground surface). A plurality of utility lines also are displayed, such as exemplary object 802 (a pipe).

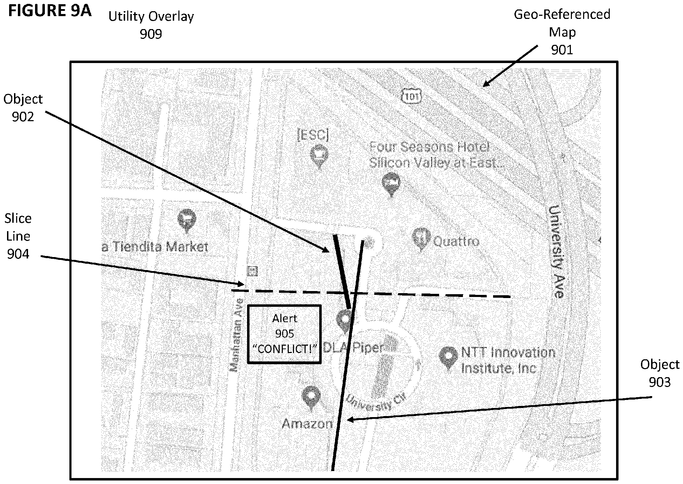

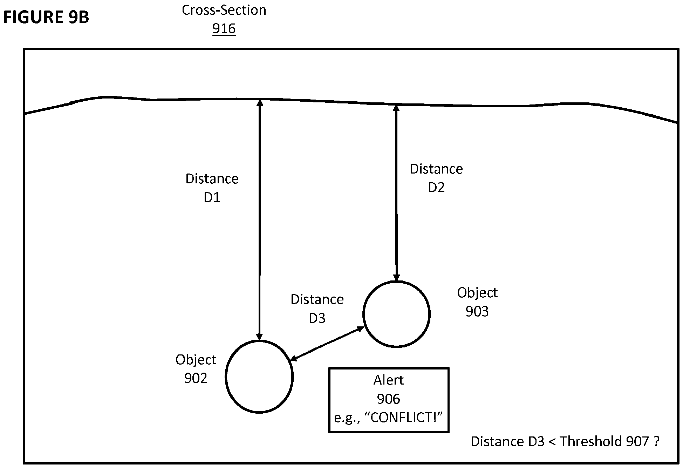

Figures 9A and 9B depict another aspect of the invention. Figure 9A depicts utility overlay 909, which comprises geo-referenced map 901, object 902, object 903, and slice line 904. Object 902 represents an existing utility line (such as a sewer pipe), and object 903 represents a utility line that the user wishes to install (such as a gas line). Slice line 904 is a user interface device that the user can drag throughout utility overlay 909. Doing so generates cross-section 910, depicted on Figure 9B. Here, alert 905 is generated, because server 300 has identified a conflict between objects 902 and 903.

Figure 9B depicts cross-section 916, which depicts the view "underground" along slice line 904 in Figure 9A. Here, the cross-section 916 includes cross-sections of object 902 (which is a distance D1 below the surface and object 903 (which is a distance D2 below the surface). Server 300 calculates the distance D3 between objects 902 and 903. Server 300 determines if distance D3 < threshold 907, which is a parameter that was set by a user or operator as the minimum distance required by objects 902 and 903, or between the types of objects corresponding to objects 902 and 903. For instance, threshold 907 might be 1 meter for a sewer pipe and a gas line. Because distance D3 in this example is 0.90 meters, alert 906 is generated because distance D3 < threshold 907.

Here, all of the images, maps, objects, alerts, and other data described above can be can be exported to KML, CSV, DXF files or other file formats.

### DATA COLLECTION DEVICES

Additional detail will now be provided regarding certain data collection devices 503 discussed previously with reference to Figure 5. Applicant refers internally to this embodiment as "INFRAENG."

Figure 10 depicts ground penetrating radar device 1000, which comprises control unit 1001, antenna 1002, and positioning unit 1003. Positioning unit 1003 optionally comprises a GPS unit or GNSS unit that communicates with GPS or GNSS satellites to determine latitude and longitude coordinates for ground penetrating radar device 1000, usually output as latitude data and longitude data. Ground penetrating radar device 1000 emits a radar signal, which enters the ground and reflects off of utility line 1010 and returns to antenna 1002. Control unit 1001 obtains geo-location data (e.g., latitude data and longitude data) from positioning unit 1003 and obtains depth data for utility line 1010 for each point or segment at which radar data is collected. Control unit 1001 then can upload the collected data to client device 100 or server 300, which can then integrate the data for utility line 1010 with other data.

Figure 11 depicts robotic camera device 1100, which comprises camera 1101, transmitter 1102, and propulsion system 1103. Robotic camera device 1100 is placed into pipe 1110. Transmitter 1102 transmits image data captured by camera 1101 to receiver 1100, which allows an operator to visually see into pipe 1110 to spot rupture or blockage 1111 and to see any cross-connections with other pipes. Receiver 1100 comprises positioning unit 1104. Positioning unit 1104 optionally comprises a GPS unit or GNSS unit that communicates with GPS or GNSS satellites to determine latitude and longitude coordinates for receiver 1100, usually output as latitude data and longitude data.

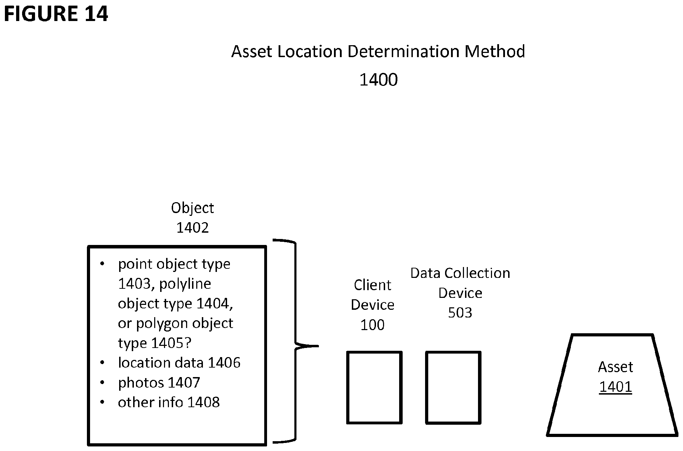

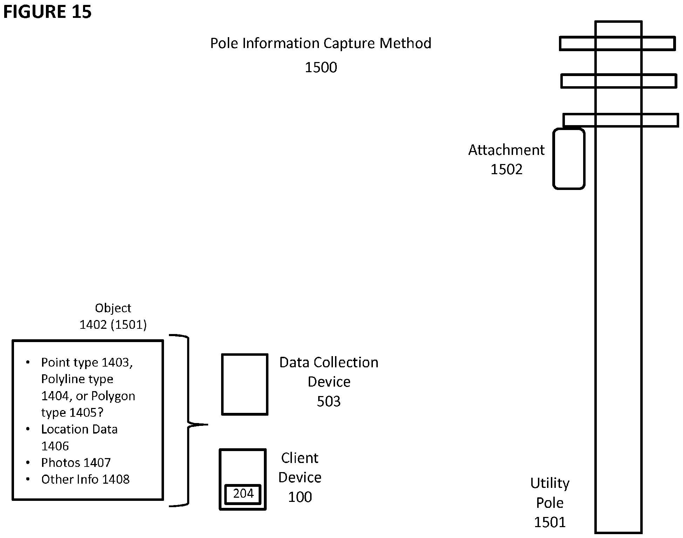

Another aspect of design system 500 will now be described with reference to the examples depicts in Figures 14 and 15.

Figure 14 depicts asset location determination method 1400 performed by design system 500. Asset 1401 is a physical item in the field that needs to be surveyed, measured, and/or located. Asset 1401 can comprise, for example, a utility pole, a utility line, a control box, a traffic light, a traffic light controller, an electrical transformer, a fire hydrant, a manhole cover, etc. A person operating client device 100 and/or measurement device 503 physically finds asset 1401. Then, client application 202 and/or server application 402 creates an object 1402. Object 1402 will have an object type, which here can comprise of a point object type 1403, a polyline object type 1404, or a polygon object type 1405.

If object 1402 is a point object type 1403, then client device 100 and/or data collection device 503 will be used to capture location data 1406 for a single point associated with asset 1401. For example, the user can place client device 100 or data collection device physically against asset 1401 and can then capture latitude data and longitude data for that point. That data is then stored as location data 1406 in object 1402 for asset 1401.

If object 1402 is a polyline object type 1403, then client device 100 and/or data collection device 503 will be used to capture location data 1406 for two or more points associated with asset 1401. For example, the user can place client device 100 or data collection device physically against asset 1401 on one side of asset 1401 and can then capture latitude data and longitude data for that point, and then the user can place client device 100 or data collection device 503 physically against asset 1401 on the other side of asset 1401 and can then capture latitude data and longitude data for that point. That data is then stored as location data 1406 in object 1402 for asset 1401.

If object 1402 is a polygon objet type 1404, then client device 100 and/or data collection device 503 will be used to capture location data 1406 for three or more points associated with asset 1401. For example, the user can place client device 100 or data collection device physically against asset 1401 on one side of asset 1401 and can then capture latitude data and longitude data for that point, and then can do the same for two other locations where client device 100 or data collection device is placed physically against asset 1401. The captured data is then stored as location data 1406 in object 1402 for asset 1401.

Client device 100 and/or data collection device 503 can capture one or more photos 1407 of assert 1401 or surrounding areas or items and can store those photos 1407 as part of object 1402 for asset 1401.

Client device 100 and/or data collection device 503 can capture other information 1408 and store it as part of object 1402 for asset 1401.

Figure 15 depicts asset pole information capture method 1500 performed by survey and data collection system 500. Here, the asset is utility pole 1501 and/or attachment 1502. Object 1402 is generated for utility pole 1501, and another object is generated for attachment 1501. The same process described in Figure 14 is applied here to Figure 15 as well. This embodiment is known as "MPole" within assignee.

Data collection device 503 and client device 100 are used to implement terrestrial photogrammetric and conventional surveying techniques to collect geospatial information of utility pole 1501 and to store it in object 1402 in order to be used in asset management processes. Client application 202 allows a user to create a vertical and horizontal profile for utility pole 1501, which also is stored in object 1402. The created profiles are georeferenced and contain descriptive information of the pole and it is attachment which easily can upload them in any GIS.

After creating object 1402, the user will take a photo of utility pole 1501 using image capture unit 106 in client device 100. Data collection device 503, such as a TS unit, obtains precise vertical and horizontal measurement of utility pole 1501. The TS unit is able to measure objects that are not convenient or safe for the user to physically access, as might be the case if the asset is located in the middle of traffic, within private property, etc. Client application 202 and data collection device 503 are able to collect measurements of utility pole 1501 from around 300 meters away from utility pole 1501, or closer.

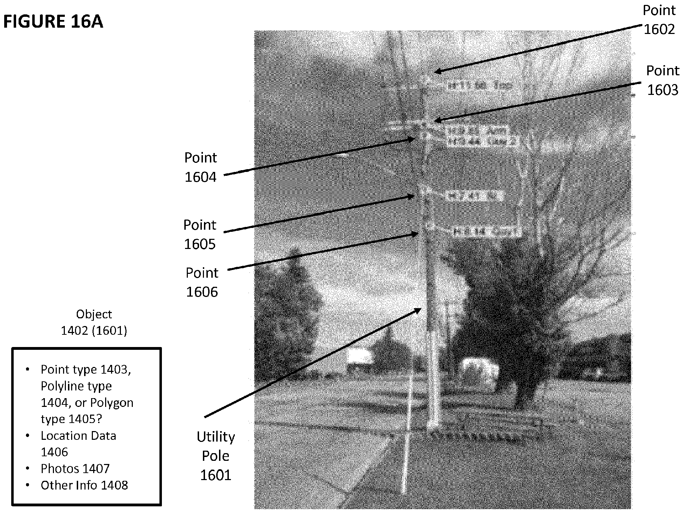

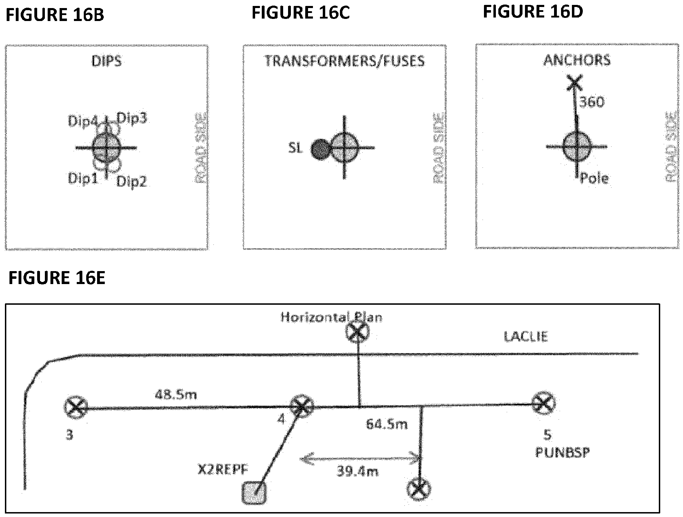

Figures 16A and 16B depict an example of an implementation of asset location determination method 1400 and/or pole information capture method 1500.

Here, client device 100 has created object 1402 (1601) for utility pole 1601. Data collection device 503 is used to capture data (such as latitude data, longitude data, and height from the ground), and a user can input data indicating the overall function of that particular point (e.g., arm to hold utility line).

Client device 100 or server 300 can then use data contained in object 1402 (1601) to create visualizations of important data. For example, Figure 16B depicts the location of dips, Figure 16C depicts the location of transformers and fuses, Figure 16D depicts the location of anchors, and Figure 16E depicts the surrounding land area, such as from a map or CAD drawing, and then shows the location of a number of objects in the field.

### AUGMENTED REALITY (AR) TOOLS

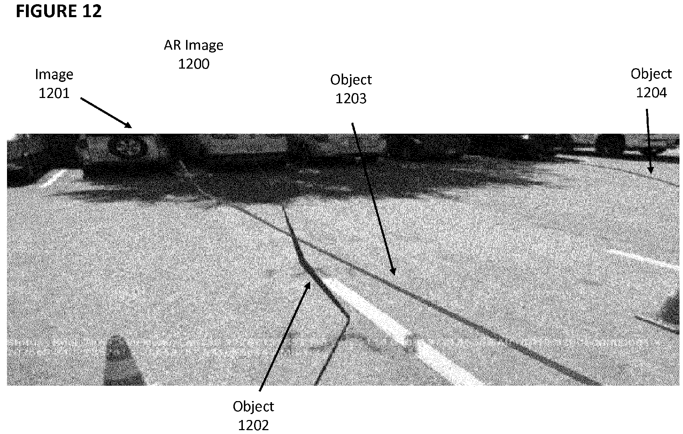

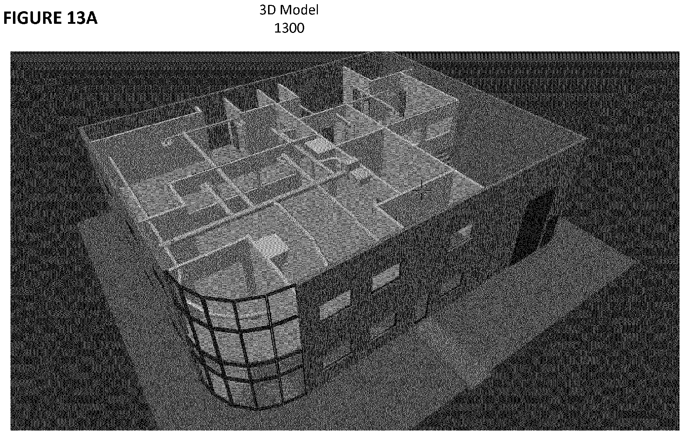

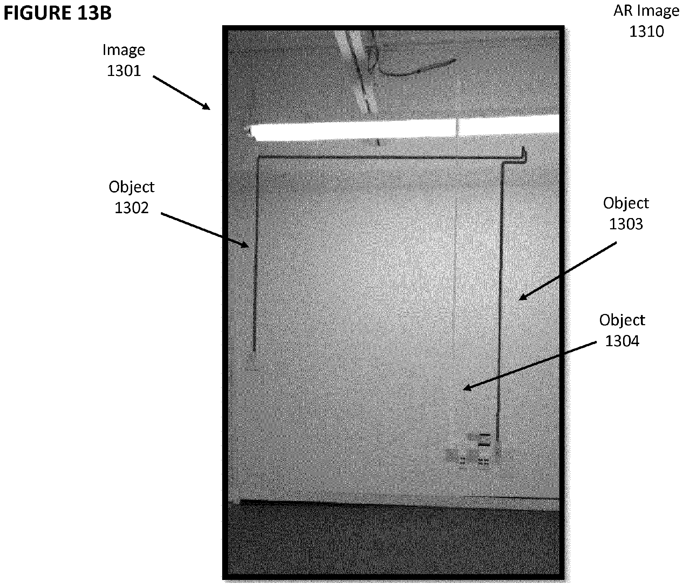

Figures 12, 13A, and 13B depict an embodiment of an AR tool used in conjunction with the embodiments described above. Applicant refers internally to this embodiment as "ARCHWAY."

In Figure 12, a user with client device 100 visits a physical site for which data exists in client device 100 and/or server 300. The user captures the physical site using image capture device 108, which displays image 1201 in real-time on display 108. Client device 108 determines the geo-location of client device 108 using positioning unit 104 and determines the orientation of client device 108 by comparison to known markers reflected in data (e.g., manhole covers). Client device 108 then generates visualizations of utility lines that are buried underground within that land area, here represented by objects 1202, 1203, and 1204, to create AR image 1200. Optionally, client device 108 also can generate visualizations of utility lines that are intended to be installed within that land area. For example, object 1202 can be a utility line that is intended to be installed but that has not yet been installed. Thus, the user will be able to "see" existing utility lines that are located under the surface in that area as well as planned utility lines. This is useful, for example, if the user is a construction worker who is going to install a new pipe and does not want to disrupt or alter any existing utility lines. Optionally, a variety of different colors can be used for the images of existing lines and planned utility lines. In particular, the color of the planned utility lines can be different than the colors used for existing utility lines.

Figure 13A and 13B depict another AR application. In Figure 13A, client device 100 or server 300 generates 3D model 1300 of a structure. This can be done, for example, during the design process when the architect or engineer builds a CAD design of the structure. Or it can be generated for an existing structure through surveying.

In Figure 13B, a user with client device 100 visits a physical site corresponding to 3D model 1300. The user captures the physical site using image capture device 108, which displays image 1201 in real-time on display 108. Client device 108 determines the geo-location of client device 108 using positioning unit 104 and determines the orientation of client device 108 by comparison to known markers reflected in data (e.g., walls). Client device 108 then generates visualizations of utility lines that are buried underground or with the walls of the displayed area, here represented by objects 1302, 1303, and 1304, to create AR image 1310. Optionally, client device 108 also can generate visualizations of utility lines that are intended to be installed within that land area. For example, object 1302 can be a utility line that is intended to be installed but that has not yet been installed. Thus, the user will be able to "see" utility lines that are located under the surface or behind walls in that area as well as planned utility lines. This is useful, for example, if the user is a construction worker who is going to install a new pipe underground or in the wall and does not want to disrupt or alter any existing utility lines. This also can be extremely useful to fire fighters who enter the scene of an incident and need to quickly determine the location of key infrastructure, such as electrical lines, gas lines, and water lines. Optionally, a variety of different colors can be used for the images of existing lines and planned utility lines. In particular, the color of the planned utility lines can be different than the colors used for existing utility lines.

One of ordinary skill in the art will appreciate that the embodiments of invention will significantly expedite the subsurface utility engineering tasks for a new project. The embodiments integrate data from multiple sources, such as city maps, geo-referenced images, maps derived from geo-referenced images, CAD files, and data collected in the field. The result is a user-friendly, permit-ready deliverable, that is quickly generated online via geographic information systems (GIS) such as design system 500.

It should be noted that, as used herein, the terms "over" and "on" both inclusively include "directly on" (no intermediate materials, elements or space disposed therebetween) and "indirectly on" (intermediate materials, elements or space disposed therebetween). Likewise, the term "adjacent" includes "directly adjacent" (no intermediate materials, elements or space disposed therebetween) and "indirectly adjacent" (intermediate materials, elements or space disposed there between), "mounted to" includes "directly mounted to" (no intermediate materials, elements or space disposed there between) and "indirectly mounted to" (intermediate materials, elements or spaced disposed there between), and "electrically coupled" includes "directly electrically coupled to" (no intermediate materials or elements there between that electrically connect the elements together) and "indirectly electrically coupled to" (intermediate materials or elements there between that electrically connect the elements together). For example, forming an element "over a substrate" can include forming the element directly on the substrate with no intermediate materials/elements therebetween, as well as forming the element indirectly on the substrate with one or more intermediate materials/elements there between.

## Claims

1. A method of visualizing the location of utility lines within a land area, comprising:
obtaining, by a computing device, a photo of a land area;
obtaining, by the computing device, a computer aided design file comprising a plurality of objects, each object representing an existing utility line located underground in the land area; and
displaying, by the computing device, images of the existing utility lines associated with the plurality of objects over the photo.

2. The method of claim 1, further comprising:
generating, by the computing device, an object for a new utility line;
displaying, by the computing device, an image for the new utility line over the photo.

3. A method of visualizing the location of utility lines within a land area, comprising:
deriving a map from a photo of a land area;
obtaining, by a computing device, the map;
obtaining, by the computing device, a computer aided design file comprising a plurality of objects, each object representing an existing utility line located underground in the land area; and
displaying, by the computing device, images of the existing utility lines associated with the plurality of objects over the map.

4. The method of claim 3, further comprising:
generating, by the computing device, an object for a new utility line;
displaying, by the computing device, an image for the new utility line over the map.

5. The method of claim 2 or 4, further comprising:
generating an alert if the distance between any portion of the new utility line and any portion of any of the existing utility lines is less than a predetermined threshold.

6. The method of claim 5, further comprising:
identifying, by the computing device, the location where any portion of the new utility line and any portion of any of the existing utility lines is less than a predetermined threshold.

7. The method of claim 6, further comprising:
displaying a cross-section of an underground area of the land area, where the cross-section includes a cross-section of the new utility line and one or more of the existing utility lines.

8. The method of any of claims 1 to 7, further comprising:
identifying a location of a first utility line using a ground penetrating radar device;
populating an object with data regarding the location of the first utility line.

9. The method of any of claims 1 to 8, further comprising:
identifying a rupture or blockage in a second utility line using a robotic camera device;
populating an object with data regarding the location of the rupture or blockage in the second utility line.

10. A method of generating an augmented reality image of a land area, comprising:
capturing a photo of a land area by a computing device;
accessing data regarding existing utility lines located underground in the land area; and
displaying, by the computing device, images of the existing utility lines over the photo.

11. The method of claim 10, further comprising:
generating, by the computing device, an object for a new utility line;
displaying, by the computing device, an image for the new utility line over the photo.

12. A method of generating an augmented reality image of a structure, comprising:
obtaining a three-dimensional model of a structure;
capturing a photo of the structure by a computing device;
accessing data from the three-dimensional model for existing utility lines contained within the structure; and
displaying, by the computing device, images of the existing utility lines over the photo.

13. The method of claim 12, wherein different colors are used for images of at least two of the existing utility lines.

14. The method of claim 12 or 13, further comprising:
generating, by the computing device, an object for a new utility line to be installed;
displaying, by the computing device, an image for the new utility line over the photo.

15. The method of claim 14, wherein a different color is used for the image of the new utility line than the colors used for the existing utility lines.
